Europäisches Patentamt

European Patent Office

Office européen des brevets

(19)

(11) **EP 0 758 167 B1**

(12) **FASCICULE DE BREVET EUROPEEN**

(45) Date de publication et mention
de la délivrance du brevet:
**17.04.2002 Bulletin 2002/16**

(51) Int Cl.⁷: **H03M 13/00**

(21) Numéro de dépôt: **96401743.8**

(22) Date de dépôt: **07.08.1996**

(54) **Procédé de décodage à sorties ponderées mettant en oeuvre l'algorithme de Viterbi en fonctionnement par blocs**

Gewichtetes Ausgangsdekodierungsverfahren unter Verwendung des Viterbi-Algorithmus

Weighted output decoding process using the Viterbi algorithm in blocks

(84) Etats contractants désignés:
**DE GB**

(30) Priorité: **08.08.1995 FR 9509610**

(43) Date de publication de la demande:
**12.02.1997 Bulletin 1997/07**

(73) Titulaire: **FRANCE TELECOM**
**75015 Paris (FR)**

(72) Inventeur: **Tortelier, Patrick**
**92110 Clichy (FR)**

(74) Mandataire: **Texier, Christian et al**
**Cabinet Régimbeau**
**20, rue de Chazelles**
**75847 Paris cedex 17 (FR)**

(56) Documents cités:
**EP-A- 0 463 598        EP-A- 0 511 139**
**EP-A- 0 512 641        EP-A- 0 553 050**
**EP-A- 0 632 612**

**Description**

La présente invention est relative à un procédé de décodage d'un code convolutif bruité, qui met en oeuvre l'algorithme de Viterbi et qui permet d'accéder à un train de symboles décodés pondérés.

L'invention trouve en particulier avantageusement application pour la transmission numérique de la parole à débit réduit ou encore pour l'égalisation de données numériques transmises par paquet ou le décodage intermédiaire de codes concaténés.

L'algorithme de Viterbi est classiquement utilisé en communications numériques et a été décrit dans :

[1] A.J. VITERBI : "Error bounds for convolutional codes and an asymptotically optimum decoding algorithm", IEEE Trans. IT., Vol 13 (1967), pp. 260-269.

Pour un bref rappel sur les codes convolutifs et leur décodage par l'algorithme de Viterbi, on pourra également avantageusement se référer à la publication suivante :

[2] J. K. OMURA : "On the Viterbi Algorithm", IEEE Trans. IT., Jan. 1979, pp. 177-179.

L'algorithme de Viterbi sélectionne dans le diagramme du treillis (diagramme représentant les transitions possibles entre les différents états du codeur) le chemin de vraisemblance maximale.

Il est souhaitable dans de nombreuses applications de pouvoir disposer d'une information symbole par symbole sur la fiabilité du décodage réalisé.

Plusieurs variantes de l'algorithme de Viterbi ont déjà été proposées pour permettre d'avoir accès à cette information.

Généralement, la fiabilité d'un symbole correspondant à un instant t donné dans une suite de symboles décodés est caractérisée par une valeur de vraisemblance calculée en sortie de l'algorithme de Viterbi à partir du rapport des probabilités respectives a posteriori du meilleur chemin décodant un 0 et du meilleur chemin décodant un 1 à cet instant t.

La vraisemblance d'un bit décodé à un instant t dépend donc non seulement des symboles reçus jusqu'à cet instant t, mais également des symboles ultérieurs.

En ce sens, il a notamment été proposé dans les deux publications suivantes :

[3] G. BATTAIL : "Pondération des symboles décodés par l'algorithme de Viterbi", Ann. Télécomm., Vol. 42 (1987), No 1-2, pp. 31-38 ;
[4] J. HAGENAUER, P. HOEHER : "A Viterbi algorithm with soft-decision output and its applications", IEEE Globecom, Dallas, 1989, pp. 47.1.1-47.1.7 ;

des variantes de l'algorithme de Viterbi dans lesquelles les valeurs de vraisemblance sont mises à jour à l'intérieur d'une fenêtre glissante.

A chaque étape, la suite des valeurs de vraisemblance déterminées pour les symboles antérieurs est révisée en fonction de la valeur de vraisemblance du nouveau symbole décodé.

Toutefois, cette mise à jour impose un traitement d'une grande complexité, notamment si l'on cherche à réaliser une révision optimale des valeurs de vraisemblance.

Par ailleurs, il a également été proposé dans :

[5] L. R. BAHL, J. COCKE, F. JELINEK, J. RAVIV : "Optimal decoding of linear codes for minimizing symbol error rate", IEEE Trans. IT., Mars 1974, pp. 284-287 ; un algorithme qui, au lieu de rechercher la suite de symboles la plus probable a posteriori, minimise de façon optimale la probabilité d'erreur sur les symboles décodés.

Cet algorithme met en oeuvre des calculs de probabilité récursifs parcourant le treillis d'une part dans le sens des t croissants et d'autre part dans le sens des t décroissants. Il est d'une grande complexité et nécessite en pratique de grandes capacités de calcul.

Une variante simplifiée de cet algorithme a également été proposé dans :

[6] R. SFEZ, G. BATTAIL : "Une variante à sortie pondérée de l'algorithme de Viterbi pour des schémas concaténés à code intérieur convolutif", Eurocode 90 (Udine, Italie).

Cette variante est basée sur une approximation correspondant au calcul classique de la vraisemblance d'un symbole élémentaire (rapport des probabilités a posteriori des meilleurs chemins décodant respectivement un 0 et un 1, à un instant t donné).

Elle met en oeuvre des traitements sur des sous-treillis et nécessite de garder à chaque étape la trace du meilleur chemin fourni par l'algorithme de Viterbi.

En outre, l'algorithme proposé dans cette publication fait intervenir une sous-fenêtre de la fenêtre de décodage et ne se prête pas à un fonctionnement par trame.

Un but principal de l'invention est donc de proposer une nouvelle variante de l'algorithme de Viterbi, qui permet d'accéder à une pondération symbole par symbole du signal en sortie et qui est d'une grande simplicité de mise en oeuvre.

Notamment, le procédé de décodage proposé par l'invention nécessite une puissance de calcul moins importante que les procédés de décodage de l'art antérieur.

Plus particulièrement, l'invention propose un procédé de décodage d'une trame de code convolutif dans lequel :

- on met en oeuvre les récurrences de l'algorithme de Viterbi pour déterminer pour chaque instant t de la trame et pour chaque noeud i la métrique du meilleur chemin issu du début de la trame et incident au noeud i à l'instant t,

caractérisé en ce que, en outre,

- on met en oeuvre des récurrences en sens inverse de celles de l'algorithme de Viterbi pour déterminer pour chaque instant t de la trame et pour chaque noeud i la métrique du meilleur chemin entre la fin de la trame et le noeud i à l'instant t,
- on calcule pour chaque noeud i et pour chaque instant t la somme des deux métriques ainsi obtenues,
- on détermine pour chaque instant t les minima d'une part sur les noeuds pairs et d'autre part sur les noeuds impairs des quantités sommes ainsi obtenues,
- on calcule la vraisemblance pour chaque instant t, qui est égale, à un facteur près, à la différence de ces deux minima.

Avec le procédé proposé par l'invention, l'opération de "Trace Back" (remontée dans le treillis du meilleur chemin retenu par l'algorithme de Viterbi) est supprimée.

Ce procédé de décodage à sorties pondérées est par exemple utilisé pour traiter les valeurs de vraisemblance ainsi déterminées pour chaque bit décodé pour rejeter uniquement les bits de la trame qui présentent une mauvaise fiabilité.

Cette correction est notamment avantageusement mise en oeuvre dans des applications de transmission numérique de la parole à débit réduit.

L'invention est également avantageusement utilisée pour l'égalisation de données numériques transmises par paquets ou pour le décodage intermédiaire de codes concaténés.

Notamment, l'invention propose un système pour la transmission de données numériques par paquets dont les moyens de réception comprennent des moyens d'égalisation de canaux à trajets multiples et un décodeur recevant les sorties des moyens d'égalisation, caractérisé en ce que les moyens d'égalisation mettent en oeuvre le procédé précité et en ce que le décodeur utilise les valeurs de vraisemblance fournies par les sorties pondérées des moyens d'égalisation, de façon à décoder de façon optimale les bits de la trame.

Elle propose également un système pour la transmission de données numériques sous la forme de codes concaténés, dont les moyens de réception comportent un décodeur interne et un décodeur externe recevant les sorties du décodeur interne, caractérisé en ce que le décodeur interne met en oeuvre le procédé précité et en ce que le décodeur externe utilise les valeurs de vraisemblance fournies par les sorties pondérées du décodeur interne, de façon à décoder de façon optimale les bits de la trame.

D'autres caractéristiques et avantages ressortiront encore de la description qui suit. Cette description est purement illustrative et non limitative. Elle doit être lue en regard des dessins annexés sur lesquels :

- la figure 1 est un schéma d'une communication numérique dont le décodeur met en oeuvre le procédé conforme à l'invention ;
- les figures 2a à 2c illustrent sur le diagramme du treillis les récurrences du procédé proposé par l'invention ;
- la figure 3 illustre schématiquement un système de transmission par paquets dans laquelle le procédé proposé par l'invention est mis en oeuvre pour l'égalisation des canaux à trajets multiples ;
- la figure 4 est un graphe sur lequel on a porté les courbes de taux d'erreur en fonction du rapport signal à bruit pour les sorties fermes et les sorties pondérées du système de transmission de la figure 3 ;
- la figure 5 illustre schématiquement un système de transmission à concaténation de codes convolutifs, dont le décodeur du code interne met en oeuvre le procédé proposé par l'invention ;
- la figure 6 est un graphe sur lequel on a porté différentes courbes de taux d'erreur en fonction du rapport signal à bruit, ces différentes courbes illustrant les performances du système de transmission de la figure 5.

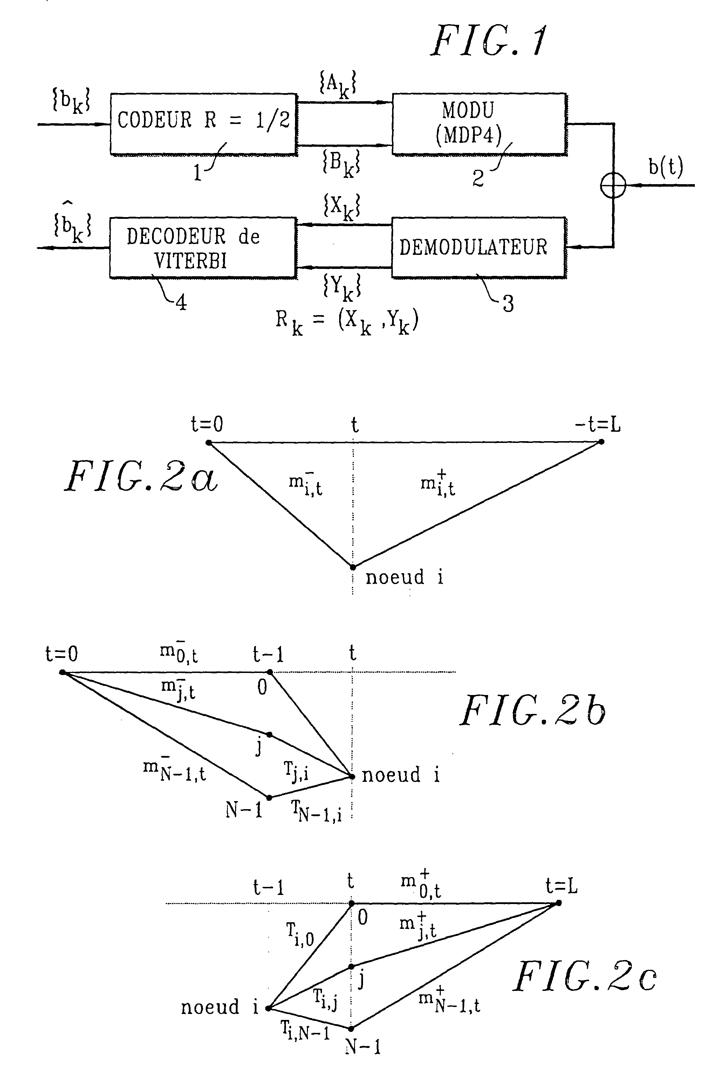

Les moyens d'émission du système de communication illustré schématiquement sur la figure 1 comportent un codeur 1 de rendement 1/2 recevant un train de symboles binaires $\{b_k\}$ et fournissant à des moyens 2 de modulation MDP4 deux trains de signaux $\{A_K\}$, $\{B_K\}$ à transmettre.

Bien entendu, l'invention s'applique de la même façon à des codages de rendement 1/N, avec N entier.

Egalement, d'autres modulations que la modulation MDP2 ou MDP4 pourraient être utilisées, seul le calcul des métriques de branches étant alors affecté.

Le signal transmis est bruité par un bruit b(t).

Les moyens de réception comportent un démodulateur 3 et un décodeur 4 qui reçoit la suite d'échantillons $R = (R_1, \dots, R_L)$ en sortie du démodulateur 3 (avec $R_K = \{X_K, Y_K\}$).

On note $\{^\wedge b_K\}$ le train de bits en sortie du décodeur 4.

Le vecteur **b** qui correspond au train de L bits en entrée du codeur 1 est avantageusement, mais non nécessairement constitué de L-K bits utiles, suivis de K zéros destinés à forcer le retour à l'état 0 du code transmis (bits d'adaptation ou "Tail Bits" selon la terminologie anglo-saxonne), K étant le degré des polynômes générateurs du codeur 1.

Au vecteur **b**, on associe le chemin de treillis C(**b**) ; c'est un chemin de L branches, partant du noeud 0 pour y retourner.

On note $Z(\mathbf{b}) = (Z_1(\mathbf{b}) \dots Z_L(\mathbf{b}))$, la suite des symboles de branches qu'on trouve sur le chemin C(**b**).

Dans le cas qui nous concerne, les $Z_i(\mathbf{b})$ et les $R_i$ sont des éléments de $R^2$.

La formule de Bayes donne la probabilité a posteriori d'un vecteur b conditionnelle à une suite $R_i$ d'échantillons reçus :

$$Pr(b|R) = \frac{Pr(b)\ Pr(R|b)}{Pr(b)}$$

Comme tous les messages **b** sont supposés équiprobables, $Pr(\mathbf{b}) = 2^{L-K}$, de plus Pr(R) est commun à toutes les hypothèses b, on est conduit à rechercher la suite **b** qui maximise $Pr(R|\mathbf{b})$. L'algorithme de Viterbi est une mise en oeuvre de ce critère. Dans le cas d'un bruit additif blanc Gaussien de variance $\sigma^2$, $Pr(R|\mathbf{b})$ est de la forme

$$Pr(R|b) = Cste \cdot \exp\left(-\frac{1}{2\sigma^2}\ \|R\text{-}Z(b)\|^2\right)$$

où

$$\|X\|2\ =\ \sum_{i=1}^{L}\ \|X_i\|_2{}^2\ ,$$

pour $X = (X_1, \dots, X_L)$ $\|.\|_2$ étant la norme de $R^2$.

t étant un nombre fixé dans l'intervalle $1 \leq t \leq L$, on considère la partition suivante de l'ensemble des vecteurs binaires **b** en deux sous-ensembles

$$B_{0,t} = \{b\ /\ b_t = 0\}, \text{ et } B_{1,t} = \{b\ /\ b_t = 1\}$$

de sorte que si $\mathbf{b} \in B_{0,t}$ (respectivement $\mathbf{b} \in B_{1,t}$), alors C(b) est un chemin du treillis qui correspond à un bit décodé 0 (respectivement 1) à l'instant t. On a de plus la constatation évidente suivante :

$$b \in B_{0,t} \Rightarrow C(\mathbf{b}) \text{ passe par un noeud pair à l'instant t.}$$

$$b \in B_{1,t} \Rightarrow C(\mathbf{b}) \text{ passe par un noeud impair à l'instant t.}$$

Les probabilités a posteriori d'obtenir un bit décodé 0 ou 1 seront donc :

$$Pr(^b_t = 0|R) = \sum_{b \in B_{0,}} Pr(b|R)$$

$$Pr(^b_t = 1|R) = \sum_{b \in B_{1,t}} Pr(b|R)$$

En appliquant la formule de Bayes, on obtient immédiatement :

$$\frac{Pr(^b_t = 0|R)}{Pr(^b_t = 1|R)} = \frac{\sum_{b \in B_{0,t}} Pr(R|b)}{\sum_{b \in B_{1,t}} Pr(R|b)} \qquad (4)$$

ou encore, en remplaçant les Pr(R|b) par leur expression

$$\frac{Pr(^b_t = 0|R)}{Pr(^b_t = 1|R)} = \frac{\sum_{b \in B_{0,t}} \exp\left(-\frac{1}{2\sigma^2}\|R-Z(b)\|^2\right)}{\sum_{b \in B_{1,t}} \exp\left(-\frac{1}{2\sigma^2}\|R-Z(b)\|^2\right)} \qquad (5)$$

L'approximation proposée consiste à considérer les meilleurs chemins correspondant respectivement à des bits décodés 0 et 1 à un instant t donné, c'est-à-dire à ne garder que les termes

$$\Delta_0 = \min_{b \in B_{0,t}} \left\{\|R-Z(b)\|^2\right\} \qquad (6)$$

$$\Delta_1 = \min_{b \in B_{1,t}} \left\{\|R-Z(b)\|^2\right\}$$

Le rapport des probabilités a posteriori de décoder un 0 ou un 1 à l'instant t est alors approximé par

$$\frac{Pr(^b_t = 0|R)}{Pr(^b_t = 1|R)} \cong \exp\left(-\frac{1}{2\sigma^2}(\Delta_0-\Delta_1)\right) \qquad (7)$$

La valeur $v_t$ de la vraisemblance à l'instant t est donc :

$$v_t = -\text{Ln}\frac{Pr(^b_t = 0|R)}{Pr(^b_t = 1|R)} \cong \text{Cste} \cdot (\Delta_0-\Delta_1) \qquad (8)$$

L'intérêt de cette approximation est que les deux quantités $\Delta_0$ et $\Delta_1$ sont des accroissements de métrique sur des chemins du treillis et correspondent aux métriques des meilleurs chemins passant respectivement par un noeud pair et par un noeud impair à l'instant t.

Il peut être démontré que la formule (7) constitue une bonne approximation du rapport des probabilités a posteriori et qu'elle est d'autant meilleure que le rapport signal à bruit augmente.

Le signe de $v_t$ donne immédiatement la décision ferme de l'algorithme de Viterbi usuel. En effet, si $\Delta_0$-$\Delta_1$ est négatif, cela signifie que le meilleur chemin dans le treillis (celui de plus petite métrique, retenu par l'algorithme de Viterbi) décode un 0 ; ; dans le cas contraire, il décode un 1. $v_t$ contient donc l'information sur la fiabilité des bits que décode l'algorithme de Viterbi usuel.

De plus, ainsi que cela va maintenant être exposé, les deux quantités $\Delta_0$ et $\Delta_1$ peuvent être calculées de manière simple à partir de l'algorithme de Viterbi.

R étant un symbole reçu, on définit une matrice carrée NxN (où N est le nombre d'états du codeur $\mathbb{T}(R)$ de la manière suivante :

$$\mathbb{T}(R) = (T_{i,j}(R)), \quad 0 \leq i,j \leq N-1$$

où $T_{i,j}$ est égal à :

. $\infty$ s'il n'y a pas de branche allant du noeud i au noeud j

. $\|R-Z_{i,j}\|^2$ sinon, $Z_{i,j}$ étant le symbole de la branche i$\rightarrow$j

M = $(m_0, m_1, ..., m_{N-1})$ désignant un vecteur de métriques de noeud, le "produit" de ce vecteur M par la matrice $\mathbb{T}$ peut être défini de deux manières différentes :

$$M' = \mathbb{T} M^T, \quad \text{où } m'_i = \min_{0 \leq j \leq N-1} \{m_j + T_{i,j}(R)\} \qquad (9.1)$$

où $M^T$ désigne le transposé du vecteur M, et

$$M'' = M \mathbb{T}, \quad \text{où } m''_i = \min_{0 \leq j \leq N-1} \{m_j + T_{j,i}(R)\} \qquad (9.2)$$

La forme (9.2) correspond au calcul classique des métriques de noeud au cours d'une étape de l'algorithme de Viterbi, elle correspond au parcours du treillis dans le sens croissant des temps. En effet, si $m_j$ désigne la métrique d'un chemin incident au noeud j, $m_j + T_{j,i}$ est la métrique de ce chemin prolongé de la branche allant du noeud j au noeud i (quand elle existe) et $m''_i$ est bien le minimum de ces quantités.

La formule (9.1) correspond au parcours du treillis en sens inverse. En effet, si $m_j$ désigne la métrique d'un chemin issu du noeud j, $m_j + T_{i,j}$ est la métrique de ce chemin prolongé vers la gauche vers le noeud i quand celui-ci est un antécédent de j.

On se réfère maintenant à la figure 2a.

Pour chaque instant t tel que $1 \leq t \leq L$, on note $m_{i,t}$ la métrique du meilleur chemin de L branches, issu du noeud 0 à t = 0, incident au noeud 0 à t = L, et passant par le noeud i à l'instant t.

Chacune des quantités $m_{i,t}$ peut être mise sous la forme

$$m_{i,t} = m^-_{i,t} + m^+_{i,t}, \quad 0 \leq i \leq N-1 \qquad (10)$$

où $m^-_{i,t}$ est la métrique du meilleur chemin issu du noeud 0 à t = 0 et incident au noeud i à l'instant t,

et où $m^+_{i,t}$ est la métrique du meilleur chemin issu du noeud i à l'instant t et incident au noeud 0 à t= L.

Ainsi qu'on l'a illustré sur la figure 2b, la quantité $m^-_{i,t}$ est obtenue en mettant en oeuvre de façon usuelle les itérations de l'algorithme de Viterbi.

En effet, en posant

$$M^-_t = (m^-_{0,t}, ..., m^-_{N-1,t})$$

on peut alors écrire :

$$M^-_0 = (0, \infty, ..., \infty)$$

$$M^-_t = M^-_{t-1} \; \mathbb{T}(R_t), \quad 1 \leq t \leq L$$

on obtient :

$$m^-_{i,t} = \min_{0 \leq j \leq N-1} \{m^-_{j,t-1} + T_{j,i}(R_t)\} \qquad (11)$$

Ainsi, pour chaque noeud (i,t), on réalise les opérations classiques d'Addition, Comparaison, Sélection : on considère les chemins arrivant à ce noeud, on met à jour leurs coûts respectifs et on choisit celui de plus petit coût.

Le calcul des quantités $m^+_{i,t}$ repose sur la constatation suivante : le meilleur chemin issu du noeud i à l'instant t et incident au noeud 0 à t = L est aussi le meilleur chemin partant du noeud 0 à t = L et incident au noeud i à l'instant t en parcourant le treillis en sens inverse

Par conséquent, les quantités $m^+_{i,t}$ peuvent être obtenues, ainsi qu'illustré sur la figure 2c, en appliquant l'algorithme de Viterbi selon des récurrences en sens inverse, c'est à dire dans un sens décroissant utilisant le produit tel que défini par la forme (9.1) :

$$M^+_L = (0, \infty, ..., \infty)$$

$$M^+_{t-1} = \mathbb{T}(R_t) \; (M^+_t)^T, \quad 1 \leq t \leq L$$

où on a posé $M^+_t = (m^+_{0,t}, ..., m^+_{N-1,t})$ ;
la dernière récurrence pouvant encore être écrite sous la forme :

$$M^+_{i,t-1} = \min_{0 \leq j \leq N-1} \{T_{i,j}(R_t) + m^+_{j,t}\} \qquad (11.2)$$

Ainsi, en mettant en oeuvre l'algorithme de Viterbi, d'une part en parcourant le treillis dans le sens des t croissants, et d'autre part en parcourant le treillis dans le sens des t décroissants, on détermine pour chaque t les quantités :

$$\Delta_0 = \min_{i \; pair} \{m^-_{i,t} + m^+_{i,t}\} \; ; \; \Delta_1 = \min_{i \; impair} \{m^-_{i,t} + m^+_{i,t}\}$$

et donc la vraisemblance $v_t$, qui est égale à un facteur près à $\Delta_0 - \Delta_1$.

On constate par conséquent que l'algorithme de décodage proposé par l'invention ne nécessite pas de garder la trace du meilleur chemin du treillis.

On conserve uniquement lors de la mise en oeuvre de l'algorithme de Viterbi dans le sens direct les métriques $m^-_{i,t}$, ainsi que les métriques de branches (matrice $\mathbb{T}(R)$), celles-ci étant utilisées lors du trajet inverse.

Le procédé de décodage proposé par l'invention a été décrit ici dans le cas où le signal à décodé est une trame de longueur finie.

Il s'applique bien entendu de la même façon au décodage d'un train d'informations en continue, en mettant en oeuvre de façon connu en soi par l'Homme du Métier, un décodage sur une fenêtre glissante.

Le traitement qui vient d'être décrit est compatible avec une éventuelle renormalisation des métriques de noeud à chaque étape.

En effet, en posant

$$\mu^{\pm}_t = \min_i m^{\pm}_{i,t},$$

on introduit les métriques normalisées $n^{\pm}_{i,t}$ par :

$$m^{\pm}_{i,t} : n^{\pm}_{i,t} + \mu^{\pm}_t$$

de sorte qu'on obtient immédiatement :

$$\Delta_0 = \min_{i\ pair} \{n^-_{i,t} + n^+_{i,t}\} + \mu^-_t + \mu^+_t$$

$$\Delta_1 = \min_{i\ impair} \{n^-_{i,t} + n^+_{i,t}\} + \mu^-_t + \mu^+_t$$

La valeur $v_t = \Delta_0 - \Delta_1$ reste inchangée si on considère seulement les métriques normalisées $n^{\pm}_{i,t}$.

Bien entendu, ce résultat reste vrai quelle que soit la méthode de renormalisation utilisée (dépassement d'un seuil par les métriques de noeud, par exemple), la propriété utile étant que la quantité $\mu^+_t + \mu^-_t$ est indépendante du numéro de noeud i.

Des simulations mettant en oeuvre le procédé qui vient d'être décrit ont été effectuées, pour évaluer le gain (en dB) par rapport à un décodeur de Viterbi classique (à sortie non pondérée, ou ferme).

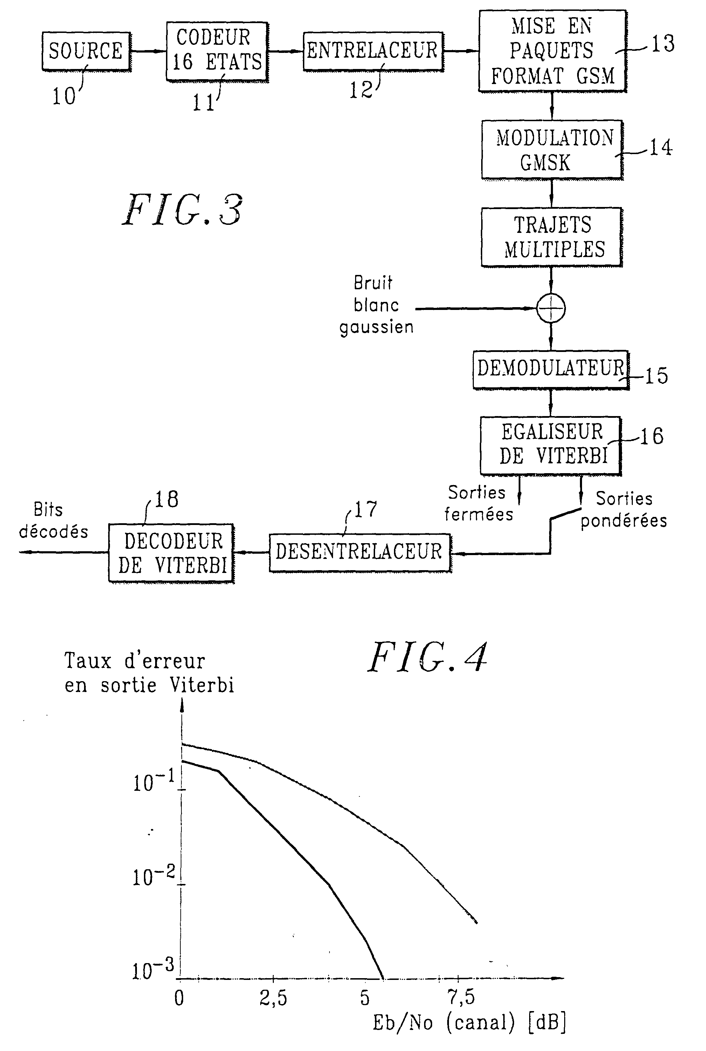

Sur la figure 3, on a illustré schématiquement un système de transmission par paquets (système GSM) dans lequel le procédé proposé par l'invention est utilisé pour réaliser un égaliseur de canaux à trajets multiples dans le cas d'une transmission par paquets.

Les moyens d'émission de ce système comportent une source de signal 10, un codeur 11 à seize états recevant le signal émis par la source, un entrelaceur 12 recevant le signal binaire en sortie du codeur 11, des moyens 13 pour mettre en forme les signaux en sortie de l'entrelaceur 12 selon des paquets correspondant au format GSM, des moyens 14 pour réaliser une modulation GMSK sur ces trames.

Les moyens de réception comportent un démodulateur 15 et un égalisateur de Viterbi à sorties pondérées 16, les signaux correspondant à ces sorties pondérées étant envoyés sur un désentrelaceur 17 en série avec un décodeur de type Viterbi classique 18 qui exploite utilement les entrées souples que constituent les sorties pondérées de l'égaliseur 16.

Le signal reçu par le démodulateur 15 est un signal bruité, qui a fait l'objet de propagations multiples.

Un tel système a été simulé en utilisant un modèle correspondant à une propagation en site urbain pour un véhicule se déplaçant à 50 km/h : il y a 6 trajets, ayant des retards et affaiblissements donnés (canal TU50).

On a supposé d'une part un entrelacement suffisamment long et d'autre part que d'un paquet au suivant l'émetteur a sauté de fréquence de manière idéale (saut de fréquence idéal) de façon à minimiser l'effet des évanouissements. On a également supposé que le bruit était un bruit blanc gaussien.

Sur la figure 4, on a représenté les courbes de taux d'erreur obtenues d'une part dans le cas où le décodeur 18 exploite les sorties pondérées de l'égaliseur 16 (courbe en trait continu) et d'autre part dans le cas où le décodeur 18 exploite uniquement les sorties fermes de l'égaliseur 16, sans tenir compte de leur pondération (courbe en pointillés).

On constate que l'utilisation d'un égaliseur à sortie pondérée procure un gain de 2.5 dB environ pour un taux d'erreur de $10^{-2}$.

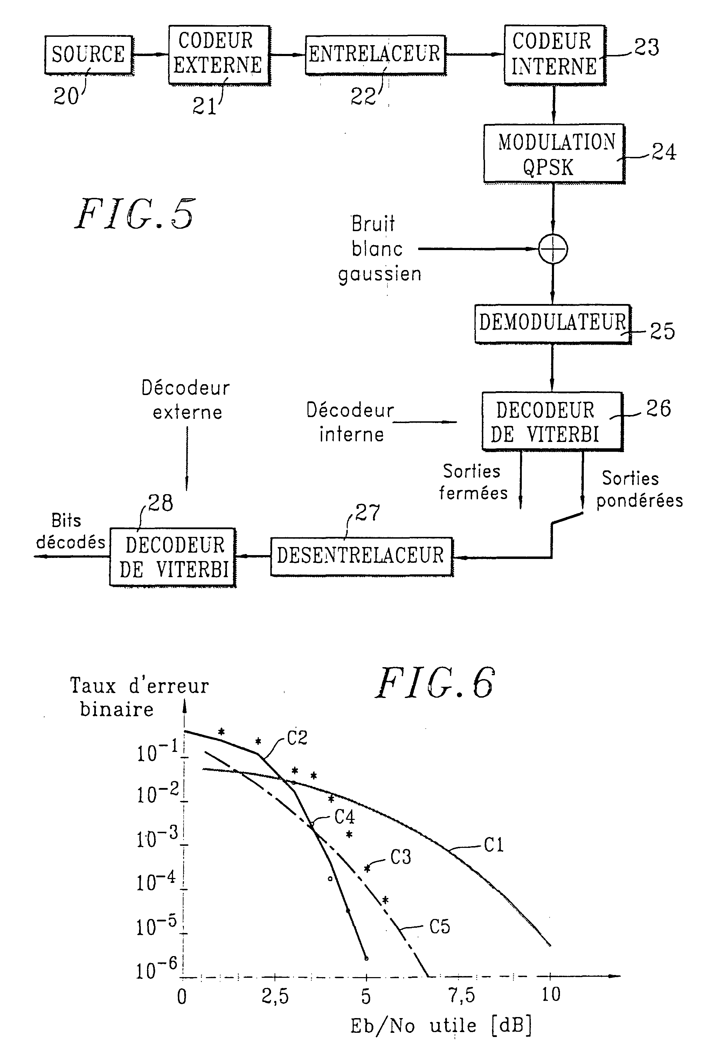

On se réfère maintenant à la figure 5 sur laquelle on a illustré un système de transmission dans lequel le procédé proposé par l'invention est utilisé pour réaliser un décodeur interne dans le cas de codes convolutifs concaténés.

A l'émission, le signal émis par une source 20 est codé par un codeur externe 21 puis envoyé sur un entrelaceur 22 dont la soprtie est codée par un codeur interne 23. Le signal en sortie de ce codeur interne 23 est envoyé sur des moyens 24 de modulation QPSK.

Les moyens de réception comportent, outre un démodulateur 25, un décodeur interne 26 constitué par un décodeur de Viterbi à sorties pondérées, un désentrelaceur 27 recevant le signal en sortie du décodeur 26 et dont la sortie est envoyée sur un décodeur externe 28 constitué par un décodeur classique de type Viterbi.

Ainsi, le décodage se fait dans l'ordre inverse du codage : le code interne est décodé en premier par le décodeur 26, le résultat étant décodé par le décodeur du code externe 27.

Un tel système de transmission a été simulé pour une configuration simple où les deux codeurs (interne et externe) sont identiques, de polynômes générateurs $1 + D^2$ et $1 + D + D^2$.

On a représenté sur la figure 6 les courbes de taux d'erreur binaire en fonction du rapport signal à bruit :

- de la sortie théorique non codée (courbe C1),
- du décodage de la sortie pondérée du code interne (courbe C2, trait continu),
- du décodage à sortie ferme du même code (courbe C3 correspondant aux points en *),
- d'un décodage semi-analytique (courbe C4 correspondant aux points en o) obtenu en considérant les valeurs souples en sortie du décodeur interne comme un signal auquel est ajouté un bruit blanc Gaussien dont on peut calculer le rapport signal/bruit équivalent,
- ainsi que du code 1/2 seul ( courbe C5 en traits mixtes).

On constate un gain de 1 dB environ entre la courbe C2 et la courbe C3.

Ce gain, inférieur à celui obtenu dans le cas décrit en référence à la figure 4, est conforme à ce que l'on peut attendre d'un point de vue théorique : en reportant cette valeur dans la courbe (simulée ou théorique) du code externe seul on obtient un résultat qui coïncide de manière excellente avec les résultats de simulation.

On remarquera que l'entrelaceur disposé entre les deux codeurs permet d'assurer l'hypothèse "Bruit blanc Gaussien".

Ainsi que cela a déjà été indiqué, l'invention est également avantageusement utilisée dans les applications de transmission de la parole à débit réduit, (par exemple 13 kbits/s dans le système paneuropéen GSM de radiotéléphone numérique pour les mobiles).

Un codeur de parole transmet périodiquement des blocs de bits (trames) contenant un certain nombre de paramètres (coefficients de filtres, excitations...) qui permettent de reconstituer le signal de parole. Ces paramètres, et, pour un même paramètre, les bits de poids forts, ont une importance subjective inégale (c'est-à-dire qu'une erreur provoque, à l'écoute, une dégradation très sensible). On classe alors les bits par importance décroissante à l'intérieur d'un certain nombre de classes de protection. Le codeur de parole du système GSM fournit ainsi toutes les 20 ms une trame de 260 bits rangés par ordre de sensibilité décroissante dans 3 classes de protection .

La classe II (78 bits) correspond aux bits les moins sensibles et ceuxs-ci ne sont pas protégés du tout.

La classe I (182 bits) est protégée par un codage correcteur d'erreurs. Les 50 premiers bits de cette classe sont très importants et un code détecteur d'erreurs déclenche habituellement le rejet de la trame entière lorsqu'il détecte une erreur non corrigée par le code correcteur (on réutilise alors la trame précédente).

En mettant en oeuvre le procédé proposé par l'invention, le code correcteur qui protège la classe I est capable, pour chaque bit décodé, de fournir une information sur la fiabilité de ce bit.

Ainsi, on rejete uniquement les paramètres douteux et non plus la trame entière.

L'information de fiabilité peut également être utilisée au niveau du décodeur de parole.

**Revendications**

1. Procédé de décodage d'une trame de code convolutif dans lequel :

   - on met en oeuvre les récurrences de l'algorithme de Viterbi pour déterminer pour chaque instant t de la trame et pour chaque noeud i la métrique ($m^-_{i,t}$) du meilleur chemin issu du début de la trame et incident au noeud i à l'instant t,

   **caractérisé en ce que**, en outre,

   - on met en oeuvre des récurrences en sens inverse de celles de l'algorithme de Viterbi pour déterminer pour chaque instant t de la trame et pour chaque noeud i la métrique ($m^+_{i,t}$) du meilleur chemin entre la fin de la trame et le noeud i à l'instant t,
   - on calcule pour chaque noeud i et pour chaque instant t la somme ($m^-_{i,t} + m^+_{i,t}$) des deux métriques ainsi obtenues,

- on détermine pour chaque instant t les minima ($\Delta_0$, $\Delta_1$) d'une part sur les noeuds pairs et d'autre part sur les noeuds impairs des quantités sommes ainsi obtenues,

- on calcule la vraisemblance ($v_t$) pour chaque instant t, qui est égale, à un facteur près, à la différence ($\Delta_0$-$\Delta_1$) de ces deux minima.

2. Procédé selon la revendication 1, **caractérisé en ce que** la trame codée est une trame de L bits comportant L - K bits utiles, complétée par K bits de remise à zéro, les récurrences en sens inverse de celles de l'algorithme de Viterbi permettant de déterminer pour chaque instant t inférieur à L et chaque noeud i la métrique du meilleur entre le noeud 0 à l'instant L et le noeud i à l'instant t.

3. Procédé de décodage selon la revendication 1, **caractérisé en ce que** les différentes étapes du traitement sont mises en oeuvre sur une fenêtre glissante.

4. Procédé de décodage selon l'une des revendications précédentes, **caractérisé en ce que** l'on traite les valeurs de vraisemblance ainsi déterminées pour chaque bit décodé pour rejeter uniquement les bits de la trame qui présentent une mauvaise fiabilité.

5. Système pour la transmission de données numériques par paquets dont les moyens de réception comprennent des moyens (16) d'égalisation de canaux à trajets multiples et un décodeur (18) recevant les sorties des moyens d'égalisation, **caractérisé en ce que** les moyens d'égalisation (16) comprennent:

- des moyens de mise en oeuvre des récurrences de l'algorithme de Viterbi pour déterminer pour chaque instant t de la trame et pour chaque noeud i la métrique ($m_{-i,t}$) du meilleur chemin issu du début de la trame et incident au noeud i à l'instant t,

- des moyens de mise en oeuvre des récurrences en sens inverse de celles de l'algorithme de Viterbi pour déterminer pour chaque instant t de latrame et pour chaque noeud i la métrique ($m_{+i,t}$) du meilleur chemin entre la fin de la trame et le noeud i à l'instant t,

- des moyens de calcul pour chaque noeud i et pour chaque instant t de la trame de la somme ($m_{-i,t} + m_{+i,t}$) des deux métriques ainsi obtenues,

- des moyens de détermination pour chaque instant t des minima ($\Delta_0$,$\Delta_1$) d'une part sur les noeuds pairs et d'autre part sur les noeuds impairs des quantités sommes ainsi obtenues, on calcule la vraisemblance ($vt$) pour chaque instant t, qui est égale, à un facteur près, à la différence ($\Delta_0$-$\Delta_1$) de ces deux minima,

et **en ce que** le décodeur (18) utilise les valeurs de vraisemblance fournies par les sorties pondérées des moyens d'égalisation, de façon à décoder de façon optimale les bits de la trame.

6. Système selon la revendication 5, **caractérisé en ce que** le décodeur est un décodeur de type Viterbi.

7. Système pour la transmission de données numériques sous la forme de codes concaténés, dont les moyens de réception comportent un décodeur interne (26) et un décodeur externe (28) recevant les sorties du décodeur interne, **caractérisé en ce que** le décodeur interne (26) met en oeuvre le procédé selon l'une des revendications 1 à 4 et **en ce que** le décodeur externe (28) utilise les valeurs de vraisemblance fournies par les sorties pondérées du décodeur interne, de façon à décoder de façon optimale les bits de la trame.

8. Système selon la revendication 7, **caractérisé en ce que** le décodeur externe est un décodeur de type Viterbi.

9. Utilisation du procédé selon la revendication 4 pour la correction de trames de transmission numérique de la parole à débit réduit.

**Claims**

1. A method of decoding a convolutional code frame, in which method:

- the recurrences of the Viterbi algorithm are used to determine, for each time $\underline{t}$ of the frame and for each node $\underline{i}$, the metric ($m^-_{i,t}$) of the best path starting from the beginning of the frame and reaching the node $\underline{i}$ at time $\underline{t}$,

**characterized in that**, additionally:

- recurrences in the opposite direction to those of the Viterbi algorithm are used to determine, for each time $\underline{t}$ of the frame and for each node $\underline{i}$, the metric ($m^+_{i,t}$) of the best path between the end of the frame and the node $\underline{i}$ at the time $\underline{t}$;
- for each node $\underline{i}$ and for each time $\underline{t}$ the sum ($m^-_{i,t} + m^+_{i,t}$) of the two metrics obtained is calculated;
- for each time $\underline{t}$ the minima ($\Delta_0, \Delta_1$) of the sum quantities obtained are determined, both over the even nodes and over the odd nodes; and
- the likelihood ($v_t$) for each time $\underline{t}$ is calculated, which is equal to the difference ($\Delta_0 - \Delta_1$) between the afore-mentioned two minima, ignoring a multiplication factor.

2. A method according to claim 1, **characterized in that** the coded frame is a frame of L bits including L - K payload bits complemented by K reset to zero bits, the recurrences in the opposite direction to those of the Viterbi algorithm being used to determine for each time $\underline{t}$ less than L and for each node $\underline{i}$ the metric of the best path between the node 0 at time L and the node $\underline{i}$ at time $\underline{t}$.

3. A decoding method according to claim 1, **characterized in that** the processing steps are executed within a sliding window.

4. A decoding method according to any preceding claim, **characterized in that** the likelihood values obtained for each decoded bit are processed to reject only the unreliable bits of the frame.

5. A system for transmitting digital data in packets, in which system receiver means include equalization means (16) for equalizing multipath channels and a decoder (18) receiving the output of the equalization means, **characterized in that** the equalization means (16) include:

- means for using the recurrences of the Viterbi algorithm to determine, for each time $\underline{t}$ of the frame and for each node $\underline{i}$, the metric ($m^-_{i,t}$) of the best path starting from the beginning of the frame and reaching the node $\underline{i}$ at time $\underline{t}$;
- means for using recurrences in the opposite direction to those of the Viterbi algorithm to determine, for each time $\underline{t}$ of the frame and for each node $\underline{i}$, the metric ($m^+_{i,t}$) of the best path between the end of the frame and the node $\underline{i}$ at the time $\underline{t}$;
- means for calculating for each node $\underline{i}$ and for each time $\underline{t}$ the sum ($m^-_{i,t} + m^+_{i,t}$) of the two metrics obtained; and
- means for determining for each time $\underline{t}$ the minima ($\Delta_0, \Delta_1$) of the sum quantities obtained, both over the even nodes and over the odd nodes, and for calucating the likelihood ($v_t$) for each time $\underline{t}$, which likelihood is equal to the difference ($\Delta_0 - \Delta_1$) between the aforementioned two minima, ignoring a multiplication factor,

and **in that** the decoder (18) uses the likelihood values provided by the weighted outputs of the equalization means to decode optimally the bits of the frame.

6. A system according to claim 5, **characterized in that** the decoder is a Viterbi decoder.

7. A system for transmitting digital data in the form of concatenated codes, in which system receiver means include an internal decoder (26) and an external decoder (28) receiving the outputs of the internal decoder, **characterized in that** the internal decoder (26) uses the method according to any one of claims 1 to 4 and **in that** the external decoder (28) uses the likelihood values supplied by the weighted outputs of the internal decoder to decode optimally the bits of the frame.

8. A system according to claim 7, **characterized in that** the external decoder is a Viterbi decoder.

9. The use of the method according to claim 4 to correct frames for digital transmission of speech at a reduced bit rate.

**Patentansprüche**

1. Verfahren zum Decodieren eines Rahmens von Faltungscode, bei welchem:

- die Rekursionen des Viterbi-Algorithmus zum Bestimmen, für jeden Zeitpunkt t des Rahmens und für jeden Knoten i, der Metrik ($m_{-i,t}$) des besten Pfads, der am Anfang des Rahmens beginnt und im Knoten i zum Zeitpunkt t ankommt, durchgeführt werden,

**dadurch gekennzeichnet, daß** außerdem

- die Rekursionen gegenläufig zu denen des Viterbi-Algorithmus zum Bestimmen, für jeden Zeitpunkt t des Rahmens und für jeden Knoten i, der Metrik ($m+_{i,t}$) des besten Pfads zwischen dem Ende des Rahmens und dem Knoten i zum Zeitpunkt t durchgeführt werden,
- für jeden Knoten i und für jeden Zeitpunkt t die Summe ($m_{-i,t} + m+_{i,t}$) der beiden so erhaltenen Metriken berechnet werden,
- für jeden Zeitpunkt t die Minima ($\Delta_0$, $\Delta_1$) .einerseits auf den geraden Knoten und andererseits auf den ungeraden Knoten der so erhaltenen summierten Größen bestimmt werden,
- die Likelihood ($v_t$) für jeden Zeitpunkt t, die bis auf einen Faktor der Differenz ($\Delta_0$-$\Delta_1$) der beiden Minima gleicht, berechnet wird.

2. Verfahren nach Anspruch 1, **dadurch gekennzeichnet, daß** der codierte Rahmen ein Rahmen von L Bits ist, welche L - K Nutz-Bits, vervollständigt durch K auf Null gesetzte Bits umfaßt, wobei die zu denen des Viterbi-Algorithmus gegenläufigen Rekursionen die Bestimmung, für jeden Zeitpunkt t kleiner als L und jeden Knoten i, der Metrik des besten Pfads zwischen dem Knoten 0 zum Zeitpunkt L und dem Knoten i zum Zeitpunkt t erlauben.

3. Verfahren zum Decodieren nach Anspruch 1, **dadurch gekennzeichnet, daß** die verschiedenen Schritte der Bearbeitung in einem gleitenden Fenster durchgeführt werden.

4. Verfahren zum Decodieren nach einem derx vorausgehenden Ansprüche, **dadurch gekennzeichnet, daß** die auf diese Weise für jedes decodierte Bit bestimmten Werte der Likelihood zum eindeutigen Verwerfen derjenigen Bits des Rahmens, die eine schlechte Zuverlässigkeit aufweisen, verwendet werden.

5. System zur Übertragung digitaler Daten durch Pakete, bei dem die Mittel zum Empfang Mittel (16) zum Entzerren von Mehrwegekanälen und einen Decoder (18), der die Ausgaben der Entzerrermittel empfängt, aufweisen, **dadurch gekennzeichnet, daß** die Mittel zur Entzerrung (16) folgendes umfassen:

- Mittel zum Durchführen der Rekursionen des Viterbi-Algorithmus zum Bestimmen, für jeden Zeitpunkt t des Rahmens und für jeden Knoten i, der Metrik ($m_{-i,t}$) des besten Pfads, der am Anfang des Rahmens beginnt und im Knoten i zum Zeitpunkt t ankommt,

- Mittel zum Durchführen der Rekursionen gegenläufig zu denen des Viterbi-Algorithmus zum Bestimmen, für jeden Zeitpunkt t des Rahmens und für jeden Knoten i der Metrik ($m+_{i,t}$) des besten Pfads zwischen dem Ende des Rahmens und dem Knoten i zum Zeitpunkt t,

- Mittel zum Berechnen, für jeden Knoten i und für jeden Zeitpunkt t, der Summe ($m_{-i,t} + m+_{i,t}$) der beiden so erhaltenen Metriken,

- Mittel zum Bestimmen, für jeden Zeitpunkt t, der Minima ($\Delta_0$,$\Delta_1$), einerseits auf den geraden Knoten und andererseits auf den ungeraden Knoten, der so erhaltenen summierten Größen, wobei die Likelihood ($v_t$) für jeden Zeitpunkt t berechnet wird, die, bis auf einen Faktor, der Differenz ($\Delta_0$-$\Delta_1$) der beiden Minima gleicht,

und dadurch, daß der Decoder (18) die von den gewichteten Ausgängen der Entzerrermittel gelieferten Likelihoodwerte verwendet, derart, daß die Bits des Rahmens auf optimale Weise decodiert werden.

6. System nach Anspruch 5, **dadurch gekennzeichnet, daß** der Decoder ein Decoder vom Viterbi-Typ ist.

7. System für die Übertragung digitaler Daten in Form verketteter Codes, bei dem die Mittel zum Empfang einen inneren Decoder (26) und einen äußeren Decoder (28), der die Ausgaben des inneren Decoders empfängt, umfaßt, **dadurch gekennzeichnet, daß** der innere Decoder (26) das Verfahren nach einem der Ansprüche 1 bis 4 durchführt, und dadurch, daß der äußere Decoder (28) die von den gewichteten Ausgängen des inneren Decoders gelieferten Likelihoodwerte verwendet, derart, daß die Bits des Rahmens auf optimale Weise decodiert werden.

8. System nach Anspruch 7, **dadurch gekennzeichnet, daß** der äußere Decoder ein Decoder vom Viterbi-Typ ist.

9. Verwendung des Verfahrens nach Anspruch 4 für die Korrektur von Rahmen der digitalen Sprachübertragung mit verdichtetem Durchsatz.

## FIG.1

$\{b_k\}$ → CODEUR R = 1/2 —— $\{A_k\}$ —→ MODU (MDP4)

$\{B_k\}$

1

2

b(t)

$\hat{\{b_k\}}$ ← DECODEUR de VITERBI ← $\{X_k\}$ ← DEMODULATEUR

$\{Y_k\}$

4

3

$R_k = (X_k, Y_k)$

FIG.2a

$t=0$   $t$   $-t=L$

$m_{i,t}^-$   $m_{i,t}^+$

noeud i

FIG.2b

$t=0$   $m_{0,t}^-$   $t-1$   $t$

$m_{j,t}^-$   $0$

$j$

$m_{N-1,t}^-$   $T_{j,i}$   noeud i

$N-1$   $T_{N-1,i}$

FIG.2c

$t-1$   $t$   $m_{0,t}^+$   $t=L$

$T_{i,0}$   $0$   $m_{j,t}^+$

$j$

noeud i   $T_{i,j}$   $m_{N-1,t}^+$

$T_{i,N-1}$   $N-1$

*FIG.3*

*FIG.4*

SOURCE — CODEUR EXTERNE — ENTRELACEUR — CODEUR INTERNE ⟍ 23

20 21 22

MODULATION QPSK ⟍ 24

*FIG.5*

Bruit blanc gaussien → ⊕

DEMODULATEUR — 25

Décodeur externe

Décodeur interne

DECODEUR DE VITERBI ⟍ 26

Sorties fermées

Sorties pondérées

Bits décodés

28

DECODEUR DE VITERBI ← DESENTRELACEUR ← 27

*FIG.6*

Taux d'erreur binaire

C2

C4

C3

C1

C5

$10^{-1}$
$10^{-2}$
$10^{-3}$
$10^{-4}$
$10^{-5}$
$10^{-6}$

0   2,5   5   7,5   10

Eb/No utile [dB]